# EUROPÄISCHE PATENTSCHRIFT

(11) **EP 3 703 201 B1**
(45) Veröffentlichungstag und Bekanntmachung des Hinweises auf die Patenterteilung: **14.05.2025**
(21) Anmeldenummer: 20163678.4
(22) Anmeldetag: 13.09.2011
(51) Int. Cl.: H01L 25/16, H10H 20/857, H01S 5/02212, H10H 20/85, H10H 20/858

(54) **GEHÄUSE FÜR EIN OPTOELEKTRONISCHES HALBLEITERBAUELEMENT**
HOUSING FOR AN OPTOELECTRONIC SEMICONDUCTOR COMPONENT
BOÎTIER POUR UN COMPOSANT SEMI-CONDUCTEUR OPTOÉLECTRONIQUE

(30) Priorität: 20.09.2010 DE 102010046090
(43) Veröffentlichungstag der Anmeldung: 02.09.2020
(62) Teilanmeldung aus: 11755076.4
(73) Patentinhaber: OSRAM Opto Semiconductors GmbH, 93055 Regensburg (DE)
(72) Erfinder: MÖLLMER, Frank, 93080 Matting bei Pentling (DE); ARZBERGER, Markus, Sunnyvale, 94086 (US); SCHWIND, Michael, 93161 Sinzing (DE); HÖFER, Thomas, 93055 Regensburg (DE)
(74) Vertreter: Epping - Hermann - Fischer

(56) Entgegenhaltungen:
- EP-A2- 0 607 700
- DE-A1- 10 260 432
- US-A- 5 825 054
- US-A1- 2002 061 036
- US-A1- 2004 032 888
- US-A1- 2005 072 985
- US-A1- 2005 194 601
- US-A1- 2007 228 535
- US-A1- 2009 103 581

## Beschreibung

Die vorliegende Anmeldung betrifft ein Halbleiterbauelement mit einem Gehäuse für ein optoelektronisches Halbleiterbauelement.

Diese Patentanmeldung beansprucht die Priorität der deutschen Patentanmeldung 10 2010 046 090. 7.

Aus den Veröffentlichungen US 5 825 054 A, US 2005/072985 A1, US 2007/228535 A1 und EP 0 607 700 A2 sind verschiedene Gehäuse für optoelektronische Halbleiterbauelemente, insbesondere für Laserdioden, aus dem Stand der Technik bekannt.

Aus den Veröffentlichungen US 2002/061036 A1 und US 2004/032888 A1 ist es aus dem Stand der Technik auch bekannt, eine elektrische Steuerschaltung in ein geformtes Gehäuse für ein optoelektronisches Halbleiterbauelement einzubauen. 1

Für Halbleiterlaserdioden mit Abwärmeleistungen bis in den Watt-Bereich finden oftmals so genannte TO-Gehäuse, beispielsweise TO56-, TO38- oder TO9-Gehäuse Anwendung. Aufgrund des vergleichsweise komplizierten Aufbaus dieser Metallgehäuse sind diese jedoch für Anwendungen im Consumer-Markt zu kostenintensiv.

Eine Aufgabe ist es ein Halbleiterbauelement mit einem Gehäuse für ein optoelektronisches Halbleiterbauelement anzugeben, das einfach und kostengünstig herstellbar ist und gleichzeitig eine gute Wärmeabfuhr aus dem Halbleiterbauelement gewährleistet.

Diese Aufgabe wird durch den Gegenstand des Patentanspruchs 1 gelöst. Ausgestaltungen und Weiterbildungen sind Gegenstand der abhängigen Patentansprüche.

Ein Halbleiterbauelement mit einem Gehäuse für ein optoelektronisches Halbleiterbauelement weist gemäß der vorliegenden Erfindung einen Gehäusekörper, einen ersten Anschlussleiter und einen zweiten Anschlussleiter auf.

Der erste Anschlussleiter und der zweite Anschlussleiter erstrecken sich in vertikaler Richtung jeweils durch den Gehäusekörper hindurch.

Der erste Anschlussleiter und der zweite Anschlussleiter ragen somit jeweils aus zwei gegenüberliegenden Seiten des Gehäusekörpers heraus. Somit können die Anschlussleiter jeweils auf der einen Seite des Gehäusekörpers für die elektrische Kontaktierung eines optoelektronischen Halbleiterchips und auf der gegenüberliegenden Seite des Gehäusekörpers der externen elektrischen Kontaktierung des Halbleiterbauelements dienen. An dem ersten Anschlussleiter ist ein Halbleiterchip befestigt.

Gemäß der vorliegenden Erfindung ist innerhalb des Gehäuses eine elektrische Steuerschaltung für den Halbleiterchip angeordnet.

In einer bevorzugten Ausgestaltung ist der Gehäusekörper ein Kunststoffkörper, der an den ersten Anschlussleiter und an den zweiten Anschlussleiter angeformt ist. Ein solcher Gehäusekörper ist mittels eines Gießverfahrens besonders einfach und kostengünstig herstellbar. Unter einem Gießverfahren wird allgemein ein Verfahren verstanden, mit dem eine Formmasse gemäß einer vorgegebenen Form ausgestaltet werden kann, beispielsweise mittels Gießens, Spritzgießens (injection molding) oder Spritzpressens (transfer molding).

Unter einer vertikalen Richtung wird im Zweifel insbesondere eine Richtung verstanden, die senkrecht zu einer Haupterstreckungsebene des Gehäusekörpers verläuft. Vorzugsweise verläuft zumindest eine der Hauptflächen des Gehäusekörpers parallel zur Haupterstreckungsebene des Gehäusekörpers.

In einer bevorzugten Ausgestaltung sind der erste Anschlussleiter und der zweite Anschlussleiter in einer zur vertikalen Richtung senkrecht verlaufenden lateralen Richtung voneinander beabstandet. Die Anschlussleiter sind also lediglich über den Gehäusekörper mechanisch stabil miteinander verbunden. Weiterhin bevorzugt verlaufen der erste Anschlussleiter und der zweite Anschlussleiter parallel zueinander.

In einer weiteren bevorzugten Ausgestaltung ist eine entlang der vertikalen Richtung verlaufende Seitenfläche des ersten Anschlussleiters als eine Montagefläche für den Halbleiterchip vorgesehen. Somit erfolgt die Abstrahlung des Halbleiterchips, der als kantenemittierender Halbleiterlaserchip ausgebildet ist, in vertikaler Richtung.

In einer weiteren bevorzugten Ausgestaltung verlaufen der erste Anschlussleiter und der zweite Anschlussleiter in einer Ebene, die durch die vertikale Richtung und durch die laterale Richtung aufgespannt wird. Mit anderen Worten verlaufen die Ebene, in der die Anschlussleiter ausgebildet sind, und die Haupterstreckungsebene des Gehäusekörpers senkrecht zueinander.

Bei der Herstellung des Gehäuses können der erste Anschlussleiter und der zweite Anschlussleiter in einfacher Weise aus einem ebenen Metallblech hervorgehen. Das Metallblech kann beispielsweise Kupfer oder eine kupferhaltige Legierung enthalten oder aus einem solchen Material bestehen.

In einer bevorzugten Ausgestaltung ist der erste Anschlussleiter derart ausgebildet, dass die im Betrieb des Halbleiterbauelements im Halbleiterchip erzeugte Abwärme effizient über den ersten Anschlussleiter abgeführt werden kann.

Vorzugsweise weist der erste Anschlussleiter einen Querschnitt von mindestens 1 mm² auf. In einem Gehäuse mit einem derartigen ersten Anschlussleiter können auch Halbleiterchips montiert werden, die im Betrieb Abwärmeleistungen von 0,1 W oder mehr erzeugen.

Der erste Anschlussleiter kann also sowohl der elektrischen als auch der thermischen Kontaktierung des Halbleiterchips dienen. Ein separater Anschluss zur Wärmeabführung ist somit nicht erforderlich.

Weiterhin bevorzugt weist der erste Anschlussleiter an jeder Stelle entlang der vertikalen Richtung einen größeren Querschnitt auf als der zweite Anschlussleiter.

In einer bevorzugten Ausgestaltung weist das Gehäuse eine Kappe auf, die den ersten Anschlussleiter und den zweiten Anschlussleiter auf einer Seite des Gehäusekörpers umgibt. Mittels der Kappe kann der Halbleiterchip vor äußeren Einflüssen wie mechanischer Belastung oder Feuchtigkeit geschützt werden. Die Kappe ist vorzugsweise auf den Gehäusekörper steckbar ausgebildet. Nach der Montage des Halbleiterchips in dem Gehäuse kann die Kappe an dem Gehäusekörper befestigt werden. Die Verbindung mit dem Gehäusekörper kann je nach Anwendung dauerhaft oder lösbar, beispielsweise mittels einer Steckverbindung oder einer Rastverbindung, ausgebildet sein.

In einer bevorzugten Ausgestaltung ist in die Kappe ein optisches Element, beispielsweise eine Linse integriert. Die Kappe kann also gleichzeitig dem Schutz des Halbleiterchips vor mechanischer Belastung und der Strahlformung, insbesondere der Kollimation der abgestrahlten Strahlung, dienen.

Die Kappe weist vorzugsweise einen Deckel und einen den Deckel umlaufenden Mantel auf. Der Deckel ist zweckmäßigerweise für die von dem Halbleiterchip zu erzeugende Strahlung, beispielsweise Strahlung im ultravioletten, sichtbaren und/oder infraroten Spektralbereich durchlässig ausgebildet. Der Deckel kann das optische Element bilden.

In einer Ausgestaltungsvariante ist die Kappe einstückig ausgebildet und strahlungsdurchlässig.

In einer alternativen Ausgestaltungsvariante weisen der Deckel und der Mantel voneinander verschiedene Materialien auf. Der Mantel muss nicht notwendigerweise für die vom Halbleiterchip zu erzeugende Strahlung durchlässig ausgebildet sein.

Beispielsweise kann der Mantel ein Metall oder eine metallische Legierung enthalten oder aus einem solchen Material bestehen.

Mittels eines strahlungsundurchlässigen Mantels kann vermieden werden, dass ungewollt Strahlung in lateraler Richtung aus dem Halbleiterbauelement austritt.

Das Gehäuse kann auch mehr als zwei Anschlussleiter aufweisen. Beispielsweise kann ein weiterer Anschlussleiter für die elektrische Kontaktierung der elektrischen Steuerschaltung vorgesehen sein.

Das beschriebene Gehäuse bezieht sich auf ein Halbleiterbauelement, bei dem der Halbleiterchip an dem ersten Anschlussleiter befestigt ist. Eine Hauptabstrahlrichtung des Halbleiterchips verläuft vorzugsweise entlang der vertikalen Richtung.

Der Halbleiterchip ist vorzugsweise frei von einer den Halbleiterchip umgebenden Umhüllung in dem Gehäuse montiert. Gegenüber einer Gehäuseform, bei der der Halbleiterchip nach der Montage an einem Leiterrahmen mit einem Vergussmaterial umgossen wird, zeichnet sich das Halbleiterbauelement durch eine hohe Alterungsstabilität aus. Die Gefahr einer Verringerung der abgestrahlten Strahlungsleistung aufgrund einer Verfärbung oder Eintrübung der Umhüllung, ist kann so ausgeschlossen werden.

Der Halbleiterchip kann mittels eines Lots am ersten Anschlussleiter befestigt werden. Eine Lotverbindung zeichnet sich durch eine hohe thermische Leitfähigkeit aus. Alternativ kann der Halbleiterchip auch mittels eines Klebemittels am ersten Anschlussleiter befestigt sein. Vorzugsweise ist der Halbleiterchip mittels eines mit elektrisch leitfähigen Partikeln hoch gefüllten Klebemittels befestigt. Unter hoch gefüllt wird in diesem Zusammenhang verstanden, dass das Klebemittel zu einem Gewichtsanteil von mindestens 80 % elektrisch leitfähige Partikel, beispielsweise Metallpartikel, etwa Silberpartikel, enthält.

Das Gehäuse ist vorzugsweise derart ausgebildet, dass der Gehäusekörper auf einer vom Halbleiterchip abgewandten Seite eine Auflagefläche bildet, auf der das Gehäuse bei der Montage auf einem Anschlussträger vollflächig oder zumindest bereichsweise aufliegt.

Weiterhin ist in das Halbleiterbauelement die elektrische Steuerschaltung für den Halbleiterchip integriert. Gemaß der Erfindung ist die elektrische steuerschaltung für den Halbleiterchip innerhalb des Gehäuses angeordnet. Eine elektrische Steuerschaltung ist beispielsweise in der Druckschrift US 2004/0032888 A1 beschrieben.

Die elektrische Steuerschaltung ist zweckmäßigerweise mit dem Halbleiterchip elektrisch leitend verbunden und weiterhin bevorzugt mittels eines weiteren Anschlussleiters extern elektrisch kontaktierbar.

Die Steuerschaltung ist bevorzugt an einem der Anschlussleiter angeordnet. Insbesondere können die Steuerschaltung und der Halbleiterchip auf dem ersten Anschlussleiter angeordnet sein.

Weitere Merkmale, Ausgestaltungen und Zweckmäßigkeiten ergeben sich aus der folgenden Beschreibung der Ausführungsbeispiele in Verbindung mit den Figuren.

Es zeigen:
Figuren 1A bis 1C ein erstes Ausführungsbeispiel, nicht Teil der beanspruchten vorliegenden Erfindung aber nützlich zum Verständnis ihres Kontextes, für ein Halbleiterbauelement mit einem Gehäuse in schematischer Aufsicht (Figur 1A) und in zwei Seitenansichten aus zueinander senkrechten Richtungen in den Figuren 1B und 1C;
Figuren 2A bis 2C ein zweites Ausführungsbeispiel, nicht Teil der beanspruchten vorliegenden Erfindung aber nützlich zum Verständnis ihres Kontextes, für ein Halbleiterbauelement mit einem Gehäuse in schematischer Aufsicht (Figur 2A) und in zwei Seitenansichten aus zueinander senkrechten Richtungen in den Figuren 2B und 2C;
Figuren 3A und 3B ein drittes Ausführungsbeispiel, nicht Teil der beanspruchten vorliegenden Erfindung aber nützlich zum Verständnis ihres Kontextes, für ein Halbleiterbauelement mit einem Gehäuse anhand von zwei Seitenansichten aus zueinander senkrechten Richtungen;
Figuren 4A bis 4C ein viertes Ausführungsbeispiel, nicht Teil der beanspruchten vorliegenden Erfindung aber nützlich zum Verständnis ihres Kontextes, für ein Halbleiterbauelement mit einem Gehäuse in schematischer Aufsicht (Figur 4A) und in zwei Seitenansichten aus zueinander senkrechten Richtungen in den Figuren 4B und 4C;
Figuren 5A und 5B ein fünftes Ausführungsbeispiel, nicht Teil der beanspruchten vorliegenden Erfindung aber nützlich zum Verständnis ihres Kontextes, für ein Halbleiterbauelement mit einem Gehäuse anhand von zwei Seitenansichten aus zueinander senkrechten Richtungen; und
Figur 6 ein sechstes Ausführungsbeispiel, dieses Mal gemäß der beanspruchten vorliegenden Erfindung, für ein Halbleiterbauelement mit einem Gehäuse anhand einer Seitenansicht.

Gleiche, gleichartige oder gleich wirkende Elemente sind in den Figuren mit denselben Bezugszeichen versehen.

Die Figuren und die Größenverhältnisse der in den Figuren dargestellten Elemente untereinander sind nicht als maßstäblich zu betrachten. Vielmehr können einzelne Elemente zur verbesserten Darstellbarkeit und/oder zum besseren Verständnis übertrieben groß dargestellt sein.

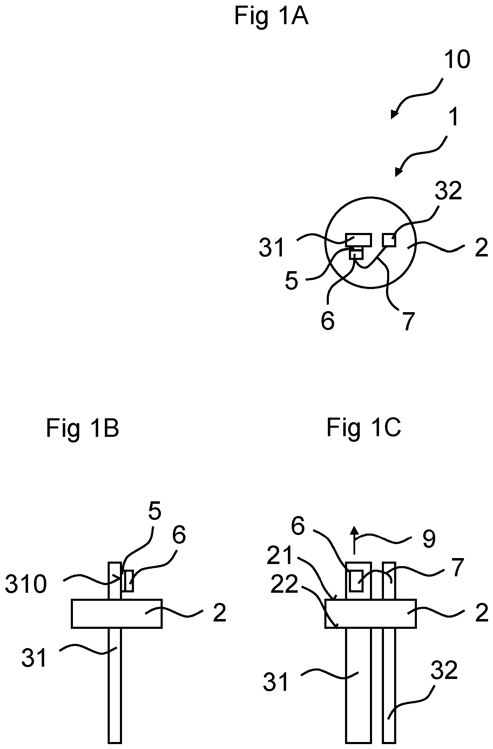

Ein erstes Ausführungsbeispiel, nicht Teil der vorliegenden Erfindung aber nützlich zum Verständnis ihres Kontextes, für ein Halbleiterbauelement 10 mit einem Gehäuse 1 und einem an dem Gehäuse befestigten Halbleiterchip 6 ist in den Figuren 1A bis 1C schematisch dargestellt. Das Gehäuse 1 weist einen Gehäusekörper 2, einen ersten Anschlussleiter 31 und einen zweiten Anschlussleiter 32 auf. Die Anschlussleiter bilden einen Leiterrahmen für das Gehäuse. Der Gehäusekörper 2 weist eine erste Hauptfläche 21 und eine zweite Hauptfläche 22 auf, zwischen denen sich der Gehäusekörper 2 in vertikaler Richtung erstreckt.

Der erste Anschlussleiter 31 und der zweite Anschlussleiter 32 verlaufen parallel zueinander und durchdringen den Gehäusekörper 2 in vertikaler Richtung, insbesondere senkrecht zu der ersten Hauptfläche. Eine durch die Anschlussleiter aufgespannte Ebene verläuft also senkrecht zur ersten Hauptfläche 21 des Gehäusekörpers. Eine in vertikaler Richtung verlaufende Seitenfläche 310 des ersten Anschlussleiters 31 bildet eine Montagefläche 310, an der der Halbleiterchip 6 an dem vorgefertigten Gehäuse 1 befestigt ist. Der Halbleiterchip 6 ist mittels einer Verbindungsschicht 5 an dem ersten Anschlussleiter 31 befestigt. Für die Verbindungsschicht eignet sich insbesondere ein Lot oder ein elektrisch leitfähiges Klebemittel. Zur Erhöhung der thermischen und elektrischen Leitfähigkeit ist das Klebemittel vorzugsweise als ein mit elektrisch leitfähigen Partikeln hoch gefülltes Klebemittel ausgeführt. Vorzugsweise enthält das Klebemittel zu einem Gewichtsanteil von mindestens 80 % elektrisch leitfähige Partikel.

Der Gehäusekörper 2 ist vorzugsweise als ein Kunststoffkörper ausgebildet, der an die Anschlussleiter 31, 32 angeformt ist. Beispielsweise kann der Gehäusekörper mittels eines Gießverfahrens, etwa durch Gießen, Spritzgießen oder Spritzpressen, hergestellt sein.

Der Kunststoffkörper kann beispielsweise ein Polymermaterial, etwa ein Flüssigkristallpolymermaterial und/oder einen Thermoplast, etwa Polyetheretherketon (PEEK), enthalten oder aus einem solchen Material bestehen.

Der erste Anschlussleiter 31 und der zweite Anschlussleiter 32 können bei der Herstellung aus einem ebenen Metallblech, beispielsweise einem Kupferblech oder einem Blech, das auf einer Kupferlegierung basiert, hergestellt sein. Beispielsweise können der erste Anschlussleiter 31 und der zweite Anschlussleiter 32 mittels Stanzens auf einfache und reproduzierbare Weise ausgebildet werden.

Der zweite Anschlussleiter 32 ist über eine Verbindungsleitung 7, etwa eine Drahtbondverbindung, mit dem Halbleiterchip 6 verbunden. Die seitens der zweiten Hauptfläche 22 aus dem Gehäusekörper 2 herausragenden Bereiche der Anschlussleiter 31, 32 können somit der externen elektrischen Kontaktierung des Halbleiterbauelements 10 dienen. Durch Verbinden der Anschlussleiter mit einer externen Stromquelle können Ladungsträger im Betrieb des Halbleiterbauelements von verschiedenen Seiten in einen zur Erzeugung von Strahlung vorgesehenen aktiven Bereich (nicht explizit dargestellt) des Halbleiterchips 6 injiziert werden und dort unter Emission von Strahlung rekombinieren.

In dem gezeigten Ausführungsbeispiel ist der Halbleiterchip 6 als ein kantenemittierender Halbleiterlaserchip ausgebildet. Eine Hauptabstrahlungsrichtung des Halbleiterchips 6 ist anhand eines Pfeils 9 veranschaulicht.

Die Hauptabstrahlungsrichtung verläuft somit in vertikaler Richtung, also senkrecht zu einer Haupterstreckungsebene des Gehäusekörpers 2.

Ein Querschnitt des ersten Anschlussleiters 31 ist zweckmäßigerweise derart an die Abwärmeleistung des zu montierenden Halbleiterchips 6 angepasst, dass die erzeugte Abwärme effizient aus dem Halbleiterchip abgeführt werden kann.

Vorzugsweise beträgt die Querschnittsfläche mindestens 1 mm². Beispielsweise hat sich gezeigt, dass mit einem Querschnitt des ersten Anschlussleiters 31 von 1 x 2,5 mm² aus einem Kupferblech und einem Lot als Verbindungsschicht ein thermischer Widerstand von 50 K/W oder weniger erzielt werden kann.

Das beschriebene Gehäuse 1 eignet sich somit insbesondere für Halbleiterchips, deren Abwärmeleistung 0,1 W oder mehr beträgt.

Das Gehäuse 1 zeichnet sich weiterhin durch seinen besonders einfachen Aufbau und seine kostengünstige Herstellbarkeit aus. Insbesondere können die Anschlussleiter 31, 32 durch einfaches Strukturieren aus einem in ebener Form vorliegenden Grundmaterial hervorgehen. Durch eine Anordnung der Haupterstreckungsebene der Anschlussleiter 31, 32 senkrecht zu der Haupterstreckungsebene des Gehäusekörpers 2 ist auf einfache Weise ein Gehäuse realisiert, bei dem ein kantenemittierender Laser in einer zur Haupterstreckungsebene des Gehäuses senkrechten Richtung seine Hauptabstrahlungsrichtung aufweist.

Bei der Montage des Halbleiterbauelements kann das Halbleiterbauelements seitens der zweiten Hauptfläche 22 des Gehäusekörpers 2 auf einem Anschlussträger, etwa einer gedruckten Leiterplatte (printed circuit board, PCB), insbesondere vollflächig aufliegen.

In dem gezeigten Ausführungsbeispiel ist der Gehäusekörper 2 in Aufsicht kreisförmig ausgebildet. Je nach Anwendung kann aber auch eine andere Grundfläche Anwendung finden, beispielsweise eine Grundfläche mit einer ovalen Grundform oder einer rechteckigen Grundform.

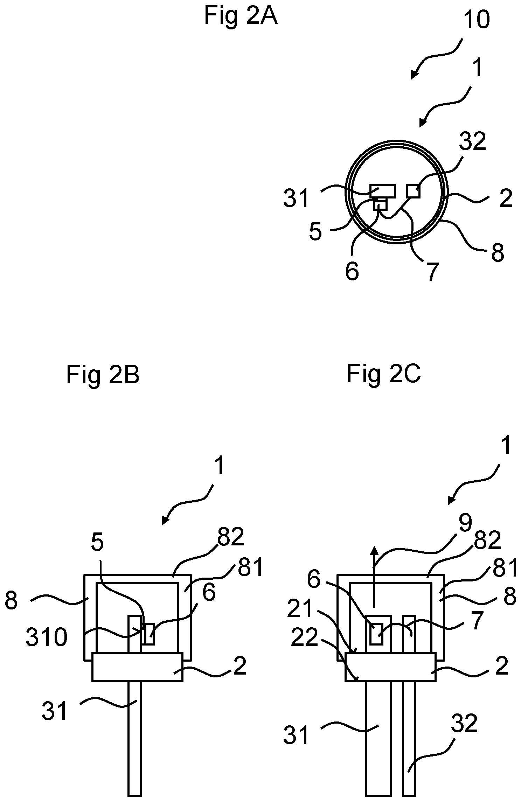

Ein zweites Ausführungsbeispiel, nicht Teil der vorliegenden Erfindung aber nützlich zum Verständnis ihres Kontextes, für ein Halbleiterbauelement 10 mit einem Gehäuse 1 ist in den Figuren 2A bis 2C schematisch dargestellt. Dieses Ausführungsbeispiel entspricht im Wesentlichen dem im Zusammenhang mit Figur 1 beschriebenen ersten Ausführungsbeispiel.

Im Unterschied hierzu weist das Gehäuse 1 zusätzlich zum Gehäusekörper 2 eine Kappe 8 auf. Die Kappe 8 umfasst einen den Gehäusekörper 2 in lateraler Richtung umlaufenden Mantel 81 und einen parallel zur ersten Hauptfläche 21 des Gehäusekörpers verlaufenden Deckel 82. In diesem Ausführungsbeispiel ist die Kappe mit Mantel und Deckel einstückig ausgebildet.

Zweckmäßigerweise ist die Kappe, insbesondere der Deckel, für die vom Halbleiterchip im Betrieb erzeugte Strahlung, beispielsweise Strahlung im ultravioletten, sichtbaren und/oder infraroten Spektralbereich transparent oder zumindest transluzent ausgebildet. Die Kappe kann beispielsweise einen Kunststoff oder ein Glas enthalten oder aus einem solchen Material bestehen.

Die Kappe 8 dient insbesondere dem Schutz des Halbleiterchips 6 vor äußeren Einflüssen wie mechanischer Belastung, Feuchtigkeit oder Staub.

Eine Umhüllung des Halbleiterchips 6 ist hierfür nicht erforderlich. Die Gefahr einer Degradation der emittierten Leistung aufgrund von Alterungseffekten des Umhüllungsmaterials kann so vermieden werden. Der von der Kappe 8 und dem Gehäusekörper 2, vorzugsweise dicht, umschlossene Innenraum des Gehäuses 1 kann luftgefüllt oder mit einem Schutzgas befüllt sein. Weiterhin kann sich der Innenraum auf normalem Atmosphärendruck, auf einem Unterdruck oder auf einem Überdruck befinden.

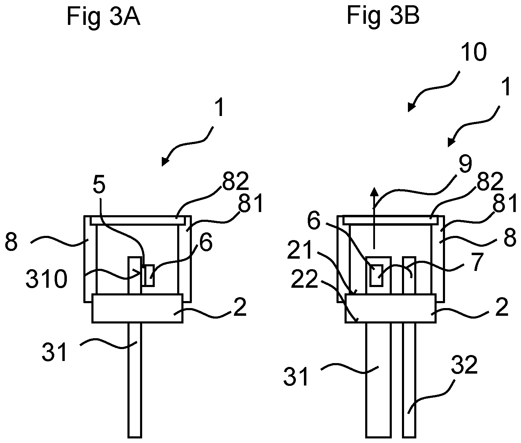

Ein drittes Ausführungsbeispiel, nicht Teil der vorliegenden Erfindung aber nützlich zum Verständnis ihres Kontextes, für ein Halbleiterbauelement mit einem Gehäuse ist in den Figuren 3A und 3B dargestellt. Dieses dritte Ausführungsbeispiel entspricht im Wesentlichen dem im Zusammenhang mit den Figuren 2A bis 2C dargestellten zweiten Ausführungsbeispiel.

Im Unterschied hierzu sind der Mantel 81 und der Deckel 82 der Kappe 8 als gesonderte Bauteile gefertigt. In diesem Fall kann der Mantel auch aus einem für die vom Halbleiterchip 6 erzeugte Strahlung undurchlässigen Material gefertigt sein. Beispielsweise kann der Mantel ein Metall oder eine metallische Legierung enthalten oder aus einem solchen Material bestehen.

Zur verbesserten Darstellbarkeit ist der Deckel 8 in den Seitenansichten jeweils lediglich in Schnittansicht dargestellt.

Der Deckel 82 ist in den Mantel 81 eingelegt und zweckmäßigerweise mechanisch stabil und dauerhaft mit dem Mantel verbunden.

Je nach Anwendung kann die Kappe 8 an dem Gehäusekörper 2 lösbar, beispielsweise abziehbar, befestigt sein oder, beispielsweise mittels eines Klebemittels, dauerhaft mechanisch stabil mit dem Gehäusekörper 2 verbunden sein.

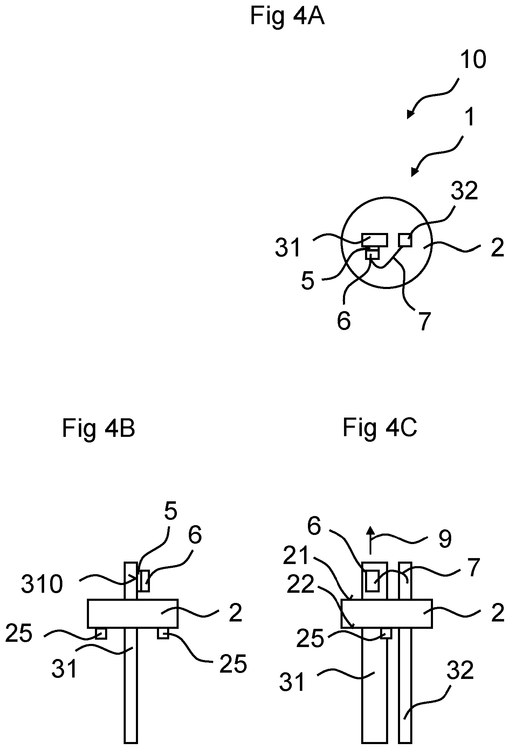

Ein viertes Ausführungsbeispiel, nicht Teil der vorliegenden Erfindung aber nützlich zum Verständnis ihres Kontextes, für ein Halbleiterbauelement ist in den Figuren 4A bis 4C schematisch dargestellt. Dieses vierte Ausführungsbeispiel entspricht im Wesentlichen dem im Zusammenhang mit den Figuren 1A bis 1C beschriebenen ersten Ausführungsbeispiel. Im Unterschied hierzu weist der Gehäusekörper 2 seitens der zweiten Hauptfläche 22 Erhebungen 25 auf. Die Erhebungen sind als Auflagepunkte bei der Montage des Halbleiterbauelements, beispielsweise auf einer gedruckten Leiterplatte, vorgesehen. In Aufsicht auf den Gehäusekörper sind die Erhebungen auf gegenüberliegenden Seiten der Anschlussleiter 31, 32 angeordnet. Die Gefahr eines Verkippens des Halbleiterbauelements ist so vermindert. Von der gezeigten Darstellung abweichend können auch mehr als zwei Erhebungen, beispielsweise drei Erhebungen, oder auch nur eine Erhebung zweckmäßig sein. Mittels der zumindest einen Erhebung ist eine genaue Positionierung des Halbleiterbauelements 10 bei der Montage vereinfacht.

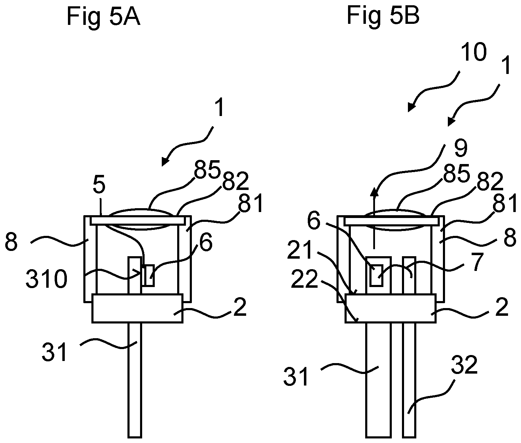

Ein fünftes Ausführungsbeispiel, nicht Teil der vorliegenden Erfindung aber nützlich zum Verständnis ihres Kontextes, für ein Halbleiterbauelement ist in den Figuren 5A und 5B schematisch dargestellt. Dieses fünfte Ausführungsbeispiel entspricht im Wesentlichen dem im Zusammenhang mit den Figuren 3A und 3B beschriebenen dritten Ausführungsbeispiel. Im Unterschied hierzu weist die Kappe 8 ein optisches Element 85 auf, das in diesem Ausführungsbeispiel exemplarisch als eine Linse ausgeführt ist. Vorzugsweise ist das optische Element zumindest auf einer Seite zumindest entlang einer Raumrichtung konvex gekrümmt. Beispielsweise kann das optische Element als eine konvexe oder eine plankonvexe Linse ausgebildet sein. Auch eine Zylinderlinse kann Anwendung finden. Die im Betrieb vom Halbleiterchip 6 erzeugte Strahlung kann mittels des optischen Elements geformt, insbesondere kollimiert werden. In dem beschriebenen Ausführungsbeispiel ist das optische Element 85 in den Deckel 82 integriert. Davon abweichend kann das optische Element auch bei einer insbesondere wie im Zusammenhang mit den Figuren 2A bis 2C beschriebenen einstückigen Ausgestaltung der Kappe 8 vorgesehen sein.

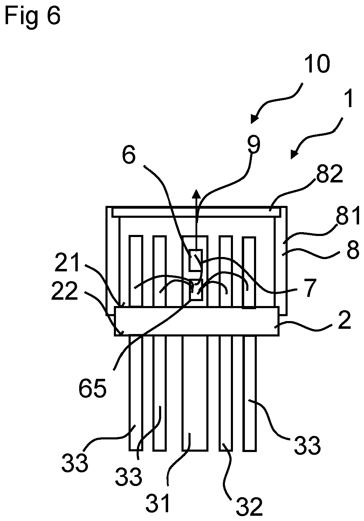

Ein sechstes Ausführungsbeispiel, dieses Mal gemäß der vorliegenden Erfindung, für ein Halbleiterbauelement ist in der Figur 6 schematisch dargestellt. Dieses sechste Ausführungsbeispiel entspricht im Wesentlichen dem im Zusammenhang mit den Figuren 3A und 3B beschriebenen dritten Ausführungsbeispiel. Im Unterschied hierzu weist das Gehäuse 1 zusätzlich zu dem ersten Anschlussleiter 31 und dem zweiten Anschlussleiter 32 drei weitere Anschlussleiter 33 auf. Die weiteren Anschlussleiter 33 sind für die elektrische Kontaktierung einer elektrischen Steuerschaltung 65 vorgesehen. Die elektrische Steuerschaltung ist vorzugsweise als ein integrierter Schaltkreis ausgestaltet. Die Steuerschaltung ist direkt mit dem Halbleiterchip 6 verbunden, beispielsweise mittels einer Verbindungsleitung 7. Aufgrund der Integration der Steuerschaltung im Inneren des Gehäuses 1 und der damit verbundenen kurzen elektrischen Verbindungsleitungen wird die Erzeugung von sehr kurzen Pulsen vereinfacht. Weiterhin kann in dem Gehäuse zumindest ein Kondensator angeordnet werden.

In dem gezeigten Ausführungsbeispiel sind der Halbleiterchip 6 und die elektrische Steuerschaltung 65 an dem ersten Anschlussleiter 31 befestigt. Aufgrund des größeren Querschnitts des ersten Anschussleiters ist eine Montage der Steuerschaltung so vereinfacht. Die Steuerschaltung kann aber auch an einem der anderen Anschlussleiter befestigt sein.

Die weiteren Anschlussleiter 33 können beispielsweise jeweils für eine Versorgungsspannung der elektrischen Steuerschaltung, für einen Massekontakt oder als ein TriggerEingang vorgesehen sein.

Selbstverständlich kann eine solche elektrische Steuerschaltung auch bei den weiteren vorstehend beschriebenen Ausführungsbeispielen des Halbleiterbauelements, insbesondere unabhängig von der konkreten Ausgestaltung der Kappe 8, Anwendung finden.

Die beschriebene Bauform des Gehäuses 1 zeichnet sich durch eine besonders hohe Flexibilität im Hinblick auf die konkrete Ausgestaltung aus. Insbesondere kann die Anzahl der Anschlussleiter bei der Herstellung auf einfache Weise variiert werden.

Der Umfang der vorliegenden Erfindung wird durch die folgenden Ansprüche definiert.

## Patentansprüche

1. Halbleiterbauelement (10) mit einem Gehäuse (1) für ein optoelektronisches Halbleiterbauelement, bei dem das Gehäuse (1) einen Gehäusekörper (2), einen ersten Anschlussleiter (31) und einen zweiten Anschlussleiter (32) aufweist, wobei sich der erste Anschlussleiter (31) und der zweite Anschlussleiter (32) in einer vertikalen Richtung jeweils durch den Gehäusekörper (2) hindurch erstrecken, ein Halbleiterchip (6) an dem ersten Anschlussleiter (31) befestigt ist,
**dadurch gekennzeichnet, dass** eine elektrische Steuerschaltung (65) für den Halbleiterchip (6) innerhalb des Gehäuses (1) angeordnet ist.

2. Halbleiterbauelement (10) nach Anspruch 1,
bei dem der Gehäusekörper (2) ein Kunststoffkörper ist, der an den ersten Anschlussleiter (31) und an den zweiten Anschlussleiter (32) angeformt ist.

3. Halbleiterbauelement (10) nach Anspruch 1 oder 2,
bei dem der erste Anschlussleiter (31) und der zweite Anschlussleiter (32) in einer zur vertikalen Richtung senkrecht verlaufenden lateralen Richtung voneinander beabstandet sind.

4. Halbleiterbauelement (10) nach einem der Ansprüche 1 bis 3,
bei dem eine entlang der vertikalen Richtung verlaufende Seitenfläche des ersten Anschlussleiters (31) als eine Montagefläche (310) für den Halbleiterchip (6) vorgesehen ist.

5. Halbleiterbauelement (10) nach einem der Ansprüche 1 bis 4,
bei dem der erste Anschlussleiter (31) und der zweite Anschlussleiter (32) in einer Ebene verlaufen, die durch die vertikale Richtung und durch die laterale Richtung aufgespannt wird.

6. Halbleiterbauelement (10) nach einem der Ansprüche 1 bis 5,
bei dem der erste Anschlussleiter (31) einen Querschnitt von mindestens 1 mm² aufweist.

7. Halbleiterbauelement (10) nach einem der Ansprüche 1 bis 6,
bei dem das Gehäuse (1) eine Kappe (8) aufweist, die den ersten Anschlussleiter (31) und den zweiten Anschlussleiter (32) auf einer Seite des Gehäusekörpers (2) umgibt.

8. Halbleiterbauelement (10) nach Anspruch 7,
bei dem die Kappe (8) auf den Gehäusekörper (2) steckbar ausgebildet ist.

9. Halbleiterbauelement (10) nach Anspruch 7 oder 8,
bei dem die Kappe (8) einstückig ausgebildet ist und für Strahlung im ultravioletten, sichtbaren und/oder infraroten Spektralbereich durchlässig ist.

10. Halbleiterbauelement (10) nach Anspruch 7 oder 8,
bei dem die Kappe einen Deckel (82) und einen den Deckel umlaufenden Mantel (81) aufweist, wobei der Deckel (82) für Strahlung im ultravioletten, sichtbaren und/oder infraroten Spektralbereich durchlässig ist und der Mantel (81) ein Metall enthält.

11. Halbleiterbauelement (10) nach einem der Ansprüche 1 bis 10,
bei dem der Halbleiterchip (6) eine Hauptabstrahlungsrichtung aufweist, die entlang der vertikalen Richtung verläuft.

12. Halbeiterbauelement (10) nach einem der Ansprüche 1 bis 11,
bei dem der Halbleiterchip (6) frei von einer den Halbleiterchip (6) umgebenden Umhüllung in dem Gehäuse (1) montiert ist.

13. Halbleiterbauelement (10) nach einem der Ansprüche 1 bis 12,
bei dem der Halbleiterchip (6) mittels eines Lots oder mittels eines mit elektrisch leitfähigen Partikeln hochgefüllten Klebemittels am ersten Anschlussleiter (31) befestigt ist.

## Claims

1. Semiconductor component (10) comprising a housing (1) for an optoelectronic semiconductor component, in which the housing (1) has a housing body (2), a first connecting lead (31) and a second connecting lead (32), the first connecting lead (31) and the second connecting lead (32) each extending in a vertical direction through the housing body (2), a semiconductor chip (6) being fastened to the first connecting lead (31),
**characterized in that** an electrical control circuit (65) for the semiconductor chip (6) is arranged inside the housing (1).

2. Semiconductor component (10) according to claim 1,
in which the housing body (2) is a plastic body which is molded onto the first connecting lead (31) and onto the second connecting lead (32).

3. Semiconductor component(10) according to claim 1 or 2,
in which the first connecting lead (31) and the second connecting lead (32) are spaced apart in a lateral direction perpendicular to the vertical direction.

4. Semiconductor component(10) according to one of claims 1 to 3,
wherein a side surface of the first connecting lead (31) extending along the vertical direction is provided as a mounting surface (310) for the semiconductor chip (6).

5. Semiconductor component(10) according to one of claims 1 to 4,
wherein the first connecting lead (31) and the second connecting lead (32) extend in a plane spanned by the vertical direction and by the lateral direction.

6. Semiconductor component(10) according to one of claims 1 to 5,
wherein the first connecting lead (31) has a cross-section of at least 1 mm².

7. Semiconductor component(10) according to one of claims 1 to 6,
wherein the housing (1) comprises a cap (8) surrounding the first connecting lead (31) and the second connecting lead (32) on one side of the housing body (2).

8. Semiconductor component (10) according to claim 7,
in which the cap (8) is configured to be pluggable onto the housing body (2).

9. Semiconductor component (10) according to claim 7 or 8, in which the cap (8) is formed in one piece and is transparent to radiation in the ultraviolet, visible and/or infrared spectral range.

10. Semiconductor component(10) according to claim 7 or 8, in which the cap has a cover (82) and a sheath (81) surrounding the cover, the cover (82) being transparent to radiation in the ultraviolet, visible and/or infrared spectral range and the sheath (81) containing a metal.

11. Semiconductor component(10) according to one of claims 1 to 10,
wherein the semiconductor chip (6) has a main radiation direction extending along the vertical direction.

12. Semiconductor component(10) according to one of claims 1 to 11,
wherein the semiconductor chip (6) is mounted in the housing (1) free from an encapsulation surrounding the semiconductor chip (6).

13. Semiconductor component(10) according to one of claims 1 to 12,
in which the semiconductor chip (6) is attached to the first connecting lead (31) by means of a solder or by means of an adhesive agent highly filled with electrically conductive particles.

## Revendications

1. Composant semi-conducteur (10) avec un boîtier (1) pour un composant semi-conducteur optoélectronique, dans lequel le boîtier (1) présente un corps de boîtier (2), un premier conducteur de raccordement (31) et un deuxième conducteur de raccordement (32), le premier conducteur de raccordement (31) et le deuxième conducteur de raccordement (32) s'étendant dans une direction verticale respectivement à travers le corps de boîtier (2), une puce semi-conductrice (6) étant fixée au premier conducteur de raccordement (31),
**caractérisé en ce qu'**un circuit de commande électrique (65) pour la puce semi-conductrice (6) est disposé à l'intérieur du boîtier (1).

2. Composant semi-conducteur (10) selon la revendication 1, dans lequel le corps du boîtier (2) est un corps en matière plastique qui est moulé sur le premier conducteur de raccordement (31) et sur le deuxième conducteur de raccordement (32).

3. Composant semi-conducteur (10) selon la revendication 1 ou 2,
dans lequel le premier conducteur de raccordement (31) et le deuxième conducteur de raccordement (32) sont espacés l'un de l'autre dans une direction latérale perpendiculaire à la direction verticale.

4. Composant semi-conducteur (10) selon l'une des revendications 1 à 3,
dans lequel une surface latérale du premier conducteur de raccordement (31) s'étendant le long de la direction verticale est prévue comme une surface de montage (310) pour la puce semi-conductrice (6).

5. Composant semi-conducteur (10) selon l'une des revendications 1 à 4,
dans lequel le premier conducteur de raccordement (31) et le deuxième conducteur de raccordement (32) s'étendent dans un plan défini par la direction verticale et par la direction latérale.

6. Composant semi-conducteur (10) selon l'une des revendications 1 à 5,
dans lequel le premier conducteur de raccordement (31) présente une section transversale d'au moins 1 mm².

7. Composant semi-conducteur (10) selon l'une des revendications 1 à 6,
dans lequel le boîtier (1) comporte un capuchon (8) qui entoure le premier conducteur de raccordement (31) et le deuxième conducteur de raccordement (32) sur un côté du corps de boîtier (2).

8. Composant semi-conducteur (10) selon la revendication 7, dans lequel le capuchon (8) est conçu pour être enfiché sur le corps du boîtier (2).

9. Composant semi-conducteur (10) selon la revendication 7 ou 8,
dans lequel le capuchon (8) est formé d'une seule pièce et est transparent au rayonnement dans le domaine spectral ultraviolet, visible et/ou infrarouge.

10. Composant semi-conducteur (10) selon la revendication 7 ou 8,
dans lequel le capuchon présente un couvercle (82) et une enveloppe (81) entourant le couvercle, le couvercle (82) étant transparent pour le rayonnement dans le domaine spectral ultraviolet, visible et/ou infrarouge et l'enveloppe (81) contenant un métal.

11. Composant semi-conducteur (10) selon l'une des revendications 1 à 10,
dans lequel la puce semi-conductrice (6) présente une direction de rayonnement principale qui s'étend le long de la direction verticale.

12. Composant semi-conducteur (10) selon l'une des revendications 1 à 11,
dans lequel la puce semi-conductrice (6) est montée dans le boîtier (1) sans enveloppe entourant la puce semi-conductrice (6).

13. Composant semi-conducteur (10) selon l'une des revendications 1 à 12,
dans lequel la puce semi-conductrice (6) est fixée au premier conducteur de raccordement (31) au moyen d'une brasure ou au moyen d'un adhésif fortement rempli de particules électriquement conductrices.
